Europäisches Patentamt

European Patent Office

Office européen des brevets

(11) Veröffentlichungsnummer: **0 212 556**
**A2**

(12) EUROPÄISCHE PATENTANMELDUNG

(21) Anmeldenummer: 86111159.9

(22) Anmeldetag: 12.08.86

(51) Int. Cl.4: **G03F 7/26**

(30) Priorität: 24.08.85 DE 3530282

(43) Veröffentlichungstag der Anmeldung:
04.03.87 Patentblatt 87/10

(84) Benannte Vertragsstaaten:
AT DE FR GB NL

(71) Anmelder: **HOECHST AKTIENGESELLSCHAFT**
**Postfach 80 03 20**
**D-6230 Frankfurt am Main 80(DE)**

(72) Erfinder: **Steppan, Hartmut, Dr. Dipl.-Chem.**
**Panoramastrasse 17**
**D-6200 Wiesbaden(DE)**
Erfinder: **Geissler, Ulrich, Dr. Dipl.-Chem.**
**Altenauer Strasse 34**
**D-6203 Hochheim/Main(DE)**

(54) Verfahren zum Entschichten von lichtgehärteten Photoresistschichten.

(57) Es wird ein Verfahren zum Entschichten von lichtgehärteten Photoresistschichten beschrieben, bei dem die Schicht mit der wäßrigen Lösung einer organischen quaternären Ammoniumbase gegebenenfalls unter Zusatz einer starken anorganischen Base behandelt wird. Dabei werden die Schichtreste zu relativ kleinen Flocken dispergiert, die sich nicht zwischen Leiterbahnen festsetzen.

EP 0 212 556 A2

## Verfahren zum Entschichten von lichtgehärteten Photoresistschichten

Die Erfindung betrifft ein Verfahren zum Entschichten bzw. Strippen von lichtgehärteten Photoresistschichten.

Beim Photoresistverfahren wird durch Belichten und Auswaschen der Photoresistschicht eine Bildschablone erzeugt, die die darunterliegende Oberfläche gegen Atz-oder Galvanisierbäder abdeckt. Wenn dieser Schritt der Metallabtragung oder -abscheidung beendet ist, wird gewöhnlich die Photoresistschablone entfernt; in manchen Fällen durch mechanisches Abziehen, zumeist aber durch Behandeln mit einer ausreichend aktiven Lösung. Für diese Entschichtung im allgemeinen Sinne hat sich in der Technik der Begriff "Strippen" eingeführt. Als Stripplösungen werden gewöhnlich Lösungen von starken Basen, z. B. wäßrige Kalilauge, verwendet. Oft werden auch organische Lösemittel, meist zusammen mit quaternären Ammoniumbasen, eingesetzt.

In der US-A 4 089 704 wird zum Entfernen einer Silikonkautschuk-Beschichtung eine Lösung von Tetramethylammoniumhydroxid in Methanol und Isopropanol angegeben.

In der US-A 4 239 661 wird eine Reinigungslösung zum Entfernen von Verunreinigungen, z. B. Fingerabdrücken oder Positiv-Photoresistresten, beschrieben, die aus einer wäßrigen Lösung von Trialkylhydroxyalkylammonium hydroxid, einem Komplexierungsmittel und einem nichtionischen Netzmittel besteht.

In der US-A 4 078 102 ist eine Entschichtungslösung für negativ und positiv arbeitende Photoresists beschrieben, die aus einer Lösung eines Alkali-, Erdalkali-oder Ammoniumhydroxids in einem Alkohol im Gemisch mit einer Carbonylverbindung besteht.

Gemäß der US-A 3 673 099 wird zum Entfernen von gehärteten Harzen, z. B. von Silikonen oder Polyvinylcinnamat, eine Mischung aus einer starken Base, z. B. einem quaternären Ammoniumhydroxid, und N-Methylpyrrolidon verwendet.

In der US-A 4 202 703 wird das Strippen eines Negativ-Photoresists mittels einer Lösung von Tetramethylammoniumhydroxid und -einem Netzmittel in einem niederen Alkohol und durch anschließendes Tauchen in Trichlorethan beschrieben.

In der Regel lassen sich Positiv-Photoresistschablonen wesentlich leichter entfernen als Negativresists. Da die Positivresists aus den unveränderten, unbelichteten Stellen der Photoresistschicht bestehen, lösen sie sich normalerweise bereits im Beschichtungslösemittel wieder auf. Dagegen sind lichtgehärtete Negativresists durch die Belichtung durchgehend vernetzt, so daß sie in den meisten Lösemitteln weitgehend unlöslich sind. Zu ihrer Entschichtung sind allgemein sehr aggressive Mittel erforderlich. Auch lösen sich die Negativresists in den Entschichtungs-bzw. Stripperlösungen nicht oder nicht vollständig auf, sondern bilden mehr oder weniger große Flocken, die sich als Bodensatz abscheiden und -je nach ihrer Größe - die Handhabung der Lösung, insbesondere in automatisch arbeitenden Verarbeitungsgeräten, erheblich stören können.

Aufgabe der Erfindung war es, ein Verfahren zum Entschichten von lichtgehärteten Photoresistschichten vorzuschlagen, das ohne organische Lösemittel auskommt und bei dem die Flockengröße vermindert wird.

Gegenstand der Erfindung ist ein Verfahren zum Entschichten von lichtgehärteten Photoresistschichten durch Behandeln mit der Lösung einer organischen quaternären Ammoniumbase.

Das erfindungsgemäße Verfahren ist dadurch gekennzeichnet, daß man eine wäßrige Lösung der Ammoniumbase einsetzt.

Gemäß einer bevorzugten Ausführungsform setzt man der Lösung weiterhin eine starke anorganische Base zu.

Als Ammoniumbasen werden vorzugsweise aliphatische quaternäre Ammoniumhydroxide, insbesondere Tetraalkylammoniumhydroxide, eingesetzt. Dabei werden Verbindun gen bevorzugt, deren Alkylgruppen 1 bis 8, besonders bevorzugt 1 bis 4 Kohlenstoffatome enthalten. Von den Alkylgruppen können eine oder mehrere durch Hydroxygruppen substituiert sein. Auch kann ein Teil der Alkylgruppen durch Alkenylgruppen ersetzt sein. Die wäßrige Lösung kann etwa 0,05 bis 2, vorzugsweise 0,1 bis 1 mol/l an quaternärer Ammoniumbase enthalten. Als anorganische Basen werden bevorzugt Alkalihydroxide eingesetzt, deren Konzentration ebenfalls zwischen 0,05 und 2, insbesondere zwischen 0,1 und 1 mol/l liegen kann.

Die Entschichtung wird im allgemeinen bei erhöhter Temperatur, vorzugsweise bei 30 bis 70° C, durchgeführt. Die Einwirkungszeit liegt dabei je nach Temperatur und Konzentration der Lösung zwischen einer halben und 5 Minuten.

Das erfindungsgemäße Verfahren wird mit negativ arbeitenden, also lichthärtbaren Resistschichten durchgeführt. Als lichthärtbare Schichten sind z. B. solche auf Basis von Polyvinylcinnamat, cyclisiertem Kautschuk, organischen Aziden, Chalkonen und Allylgruppen enthaltenden Polymeren geeignet. Mit besonderem Vorteil läßt sich das Verfahren mit photopolymerisierbaren Materialien durchführen. Diese enthalten als wesentliche Bestandteile ihrer Aufzeichnungsschicht eine polymerisierbare Verbindung mit mindestens zwei endständigen ethylenisch ungesättigten Doppelbindungen, ein polymeres Bindemittel und einen Photoinitiator, der unter Einwirkung von aktinischer Strahlung die radikalische Polymerisation der ethylenisch ungesättigten Verbindung einzuleiten vermag. Als weitere Bestandteile kann die Schicht Stabilisatoren bzw. Inhibitoren zur Verhinderung der Dunkelpolymerisation der Monomeren, Wasserstoffdonatoren, Netzmittel, Weichmacher, sensitometrische Regler, Farbstoffe und farblose oder Farbpigmente enthalten.

Für die Zwecke der Erfindung geeignete photopolymerisierbare Monomere sind bekannt und z. B. in den US-A 2 760 863 und 3 060 023 beschrieben.

Bevorzugte Beispiele sind Acryl-und Methacrylsäureester, wie Polyethylenglykoldimethacrylat, Acrylate und Methacrylate von Trimethylolethan, Trimethylolpropan und Pentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079 und 23 61 041 beschrieben.

Als Bindemittel werden vorzugsweise solche verwendet, die in wäßrig-alkalischen Lösungen löslich oder mindestens quellbar sind. Als Beispiele hierfür seien genannt: Maleinatharze, Polymerisate aus N-(p-Tolylsulfonyl)-carbaminsäure-(β-methacryloyloxy-ethyl)ester und Mischpolymerisate dieser und ähnlicher Monomerer mit anderen Monomeren sowie Styrol-MaleinsäureanhydridMischpolymerisate. Methylmethacrylat-Methacrylsäure-Mischpolymerisate und Mischpolymerisate aus Methacrylsäure, Alkylmethacrylaten und Methylmethacrylat und/oder Styrol, Acrylnitril u. a., wie sie in den DE-A 20 64 080 und 23 63 806 beschrieben sind, werden bevorzugt.

Die folgenden Beispiele erläutern die Vorteile des erfindungsgemäßen Verfahrens.

Wenn nichts anderes angegeben ist, sind Prozentzahlen und Mengenverhältnisse in Gewichtseinheiten zu verstehen. Gewichtsteile (Gt) und Volumteile (Vt) stehen im Verhältnis von g zu cm³.

Zur Prüfung der Entschichtbarkeit wurden zwei verschiedene 38 μm dicke Trockenresistschichten der nachstehend angegebenen Zusammensetzung auf 25 μm dicke Polyethylenterephthalatfolien aufgebracht und mit 20 μm dicken Polyethylenfolien abgedeckt. In einem handelsüblichen Trockenresist-Laminator wurden die Deckfolien aus Polyethylen abgezogen und die Resistschichten unter Druck und Erwärmen auf Leiterplatten laminiert, die aus Isolierstoffplatten mit 35 μm dicker Kupferauflage bestanden. Die Trockenresistschichten hatten die folgende Zusammensetzung:

Resistschicht 1

6,5 Gt eines Terpolymerisats aus n-Hexylmethacrylat, Methacrylsäure und Styrol (60 : 35 : 5),

8,8 Gt eines durch Umsetzung von 1 mol Triethylenglykol, 2 mol 2,2,4-Trimethylhexamethylendiisocyanat und 2 mol Hydroxyethylmethacrylat hergestellten polymerisierbaren Urethans,

0,25 Gt 9-Phenylacridin und

0,025 Gt eines blauen Azofarbstoffs, erhalten durch Kuppeln von 2,4-Dinitro-6-chlor-benzoldiazoniumsalz mit 2-Methoxy-5-acetylamino-N,N-diethylanilin

Resistschicht 2

6,5 Gt eines Terpolymerisats aus n-Hexylmethacrylat, Methacrylsäure und Styrol (60 : 30 : 10),

5,6 Gt eines durch Umsetzung von 1 mol 2,2,4-Trimethylhexamethylendiisocyanat und 2 mol Hydroxyethylmethacrylat erhaltenen polymerisierbaren Urethans,

0,15 Gt Triethylenglykoldimethacrylat,

0,2 Gt9-Phenylacridin,

0,015 Gt Michlers Keton und

0,06 Gt des blauen Azofarbstoffs aus Resist schicht 1

Die beschichteten Leiterplatten wurden unter einer Vorlage belichtet und in einem Sprühentwicklungsgerät mit 1 %iger Natriumcarbonatlösung entwickelt. Als Vorlage wurde ein Schaltungsmuster verwendet, das neben Linien und Kreisflächen unterschiedlicher Breite bzw. Größe einen breiten transparenten Streifen über die gesamte Bildlänge enthielt, um die Wirksamkeit besonders bei großflächigen gehärteten Schichtbereichen beurteilen zu können. Zur Entschichtung der entwickelten Platten wurden 200 ml Stripperlösung in ein 200 ml fassendes Becherglas von 6 cm Durchmesser eingefüllt und auf 50° C erwärmt. Anschließend wurde die Lösung mit einem Magnetrührer gerührt, und eine der entwickelten Platten wurde darin eingetaucht. Beginn und Ende der Schichtablösung wurden notiert. Die Lösung wurde insgesamt 15 Minuten gerührt. Nach Absetzen der Fladen wurde deren Größe beurteilt.

Die Fladengrößen sind mit Werten auf einer Skala von 0 bis 6 für die jeweils größten Fladen eines Versuchs bezeichnet, wobei 0 die kleinste, 6 die größte Fläche bezeichnet. Wenn die größten Fladen bei einem Versuch kleiner als 1 mm² waren, wurde die Größe mit 0 angegeben; bei maximalen Fladengrößen von 0,5 cm² oder etwas darüber wurde der Wert 6 gewählt. In den anliegenden photographischen Aufnahmen sind zur Veranschaulichung Fladen der Größen 2 bis 6 in natürlicher Größe wiedergegeben.

Die Ergebnisse sind in der folgenden Tabelle zusammengefaßt:

| Resist-schicht | Lösung | Beginn | Ende | Fladen-größe |
|---|---|---|---|---|
| | | der Entschich-tung (Sek.) | | |
| 1 | 2,8 % KOH (0,5 mol/l) | 70 | 90 | 5 |
| 1 | 5,6 % KOH (1 mol/l) | 50 | 60 | 6 |
| 2 | 2,8 % KOH (0,5 mol/l) | 80 | 130 | 3 |
| 2 | 5,6 % KOH (1 mol/l) | 60 | 80 | 4 |
| 1 | 9,1 % TMAH.$5H_2O$ (0,5 mol/l) | 40 | 145 | 1 |
| 1 | 18,1 % TMAH.$5H_2O$ (1 mol/l) | 40 | 55 | 2-3 |
| 1 | 9,1 % TMAH.$5H_2O$ +0,5 % KOH | 55 | 85 | 2 |
| | 9,1 % TMAH.$5H_2O$ +1 % KOH | 50 | 65 | 2-3 |
| | 9,1 % TMAH.$5H_2O$ +2 % KOH | 45 | 55 | 3 |

Fortsetzung der Tabelle

| Resist-schicht | Lösung | Beginn | Ende | Fladen-größe |
|---|---|---|---|---|
| | | der Entschich-tung (Sek.) | | |
| 1 | 4,5 % TMAH.5H$_2$O<br>+ 0,5 % KOH | 65 | 160 | 2-3 |
| | 4,5 % TMAH.5H$_2$O<br>+ 1 % KOH | 60 | 100 | 2-3 |
| | 4,5 % TMAH.5H$_2$O<br>+ 2 % KOH | 50 | 70 | 3 |
| 1 | 2,3 % TMAH.5H$_2$O<br>+ 1 % KOH | 80 | 155 | 2 |
| | 2,3 % TMAH.5H$_2$O<br>+ 2 % KOH | 60 | 85 | 3 |
| 1 | 1,1 % TMAH.5H$_2$O<br>+ 1 % KOH | 110 | 230 | 2 |
| | 1,1 % TMAH.5H$_2$O<br>+ 2 % KOH | 75 | 105 | 2-3 |
| | 1,1 % TMAH.5H$_2$O<br>+ 3 % KOH | 55 | 80 | 2-3 |
| | 1,1 % TMAH.5H$_2$O<br>+ 4 % KOH | 55 | 75 | 3 |
| 1 | 0,6 % TMAH.5H$_2$O<br>+ 2 % KOH | 100 | 140 | 3-4 |
| 1 | 0,3 % TMAH.5H$_2$O<br>+ 2 % KOH | 100 | 140 | 3-4 |

Fortsetzung der Tabelle

| Resist-schicht | Lösung | Beginn | Ende | Fladen-größe |
|---|---|---|---|---|
| | | der Entschich-tung (Sek.) | | |
| 2 | 9,1 % TMAH.5H$_2$O | 70 | 215 | 0 |
| 2 | 18,1 % TMAH.5H$_2$O | 45 | 95 | 0-1 |
| 2 | 9,1 % TMAH.5H$_2$O + 0,5 % KOH | 60 | 130 | 0-1 |
| | 9,1 % TMAH.5H$_2$O + 1 % KOH | 50 | 100 | 0-1 |
| | 9,1 % TMAH.5H$_2$O + 2 % KOH | 40 | 75 | 0-1 |

TMAH = Tetramethylammoniumhydroxid

Ähnliche Ergebnisse wurden mit wäßrigen Lösungen anderer Alkylammoniumhydroxide, z. B. Tetraethylammoniumhydroxid (TEAH), Trimethyl(2-hydroxyethyl)ammoniumhydroxid (Cholin) oder Diallyldimethylammoniumhydroxid (DADMAH) erhalten:

| Resist-schicht | Lösung | Beginn | Ende | Fladen-größe |
|---|---|---|---|---|
| | | der Entschich-tung (Sek.) | | |
| 1 | 14,7 % TEAH (1 mol/l) | 65 | 110 | 2 |
| 1 | 12,1 % Cholin (1 mol/l) | 50 | 80 | 2 |
| 1 | 14,3 % DADMAH (1 mol/l) | 60 | 100 | 2 |

Galvanisierte Platten lassen sich nur einwandfrei entschichten, wenn die Fladengröße des Resists in der Beurteilung zwischen 0 und 3 liegt.

Bei Bildung größerer Fladen bleiben diese insbesondere in engen Kanälen zwischen Leiterzügen hängen, was beim anschließenden Ätzen zu Fehlern führt.

**Ansprüche**

1. Verfahren zum Entschichten von lichtgehärteten Photoresistschichten durch Behandeln mit der Lösung einer organischen quaternären Ammoniumbase, dadurch gekennzeichnet, daß man eine wäßrige Lösung der Ammoniumbase einsetzt.

2. Verfahren nach Anspruch 1, dadurch gekennzeichnet, daß man der Lösung eine starke anorganische Base zusetzt.

3. Verfahren nach Anspruch 1, dadurch gekennzeichnet, daß man eine belichtete photopolymerisierbare Schicht entschichtet.

4. Verfahren nach Anspruch 3, dadurch gekennzeichnet, daß die photopolymerisierbare Schicht ein wasserunlösliches, in wäßrig-alkalischen Lösungen lösliches oder. mindestens quellbares polymeres Bindemittel enthält.

5. Verfahren nach Anspruch 1, dadurch gekennzeichnet, daß die quaternäre Ammoniumbase ein Tetraalkylammoniumhydroxid ist, dessen Alkylgruppen 1 bis 8 Kohlenstoffatome enthalten.

6. Verfahren nach Anspruch 5, dadurch gekennzeichnet, daß mindestens eine der Alkylgruppen durch eine Hydroxylgruppe substituiert ist.

7. Verfahren nach Anspruch 1, dadurch gekennzeichnet, daß die quaternäre Ammoniumbase Alkyl-und Alkenylgruppen als Substituenten am Stickstoffatom enthält.

8. Verfahren nach Anspruch 1, dadurch gekennzeichnet, daß die Lösung 0,05 bis 2 mol/l quaternäre Ammoniumbase enthält.

9. Verfahren nach Anspruch 2, dadurch gekennzeichnet, daß die Lösung 0,05 bis 2 mol/l eines Alkalihydroxids enthält.